(19) Europäisches Patentamt
European Patent Office
Office européen des brevets

(11) Publication number: **0 028 675**
**B1**

(12) # EUROPEAN PATENT SPECIFICATION

(45) Date of publication of patent specification: **06.06.84**

(21) Application number: **80104392.8**

(22) Date of filing: **25.07.80**

(51) Int. Cl.³: **H 03 D 1/22**, H 03 D 3/18, H 01 L 29/66, H 04 L 27/14

(54) **CCD integrated circuit.**

(30) Priority: **29.08.79 US 70560**

(43) Date of publication of application: **20.05.81 Bulletin 81/20**

(45) Publication of the grant of the patent: **06.06.84 Bulletin 84/23**

(84) Designated Contracting States: **DE FR GB**

(56) References cited:
DE - A - 2 721 812
DE - A - 2 805 506
DE - B - 2 129 420
US - A - 3 781 574
US - A - 3 881 117
US - A - 3 961 275
US - A - 4 010 484
US - A - 4 051 469
US - A - 4 152 606
US - A - 4 159 430

(73) Proprietor: **Rockwell International Corporation**
**3370 Miraloma Avenue**
**Anaheim California 92803 (US)**

(72) Inventor: **French, Barry Travis**
**2500 Deer Park**
**Fullerton California 92635 (US)**
Inventor: **McNutt, Michael John**
**6081 Amberdale Drive**
**Yorba Linda California 92686 (US)**

(74) Representative: **Wagner, Karl H.**
**WAGNER & GEYER Patentanwälte**
**Gewuerzmuehlstrasse 5 Postfach 246**
**D-8000 München 22 (DE)**

(56) References cited:
**NACHRICHTENTECHNISCHE ZEITSCHRIFT (ntz) Vol. 30, No. 7 1977 G. RUOPP "Frequenzdemodulation durch Verzögerung"**
**ELECTRONICS LETTERS, Vol. 15, No. 16, August 1979 F.G.A. COUPE "Digital Frequency Discriminator" pages 489 to 490**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 028 675 B1

Courier Press, Leamington Spa, England.

## Description

The present invention is concerned with a circuit for performing demodulation of phase or amplitude modulated time-varying signals. Although various types of demodulators are known in the art, none are capable of operating directly on signals having frequencies ranging from the audio into the gigaHertz (GHz) range. Those UHF and SHF demodulators which do exist are fairly complex, and there are limits in the type of applications in which such devices can be used.

Moreover, the present invention is preferably implemented as a semiconductor integrated circuit using charge coupled device (CCD) technology. More particularly, the device uses a known type of CCD input circuit known as the Tompsett or "fill and spill" input, described in U.S. Patent No. 3,881,117.

Although various applications of CCD circuits to high frequency signal processing is known (e.g., U.S. Patent Numbers 4,152,606 and 4,159,430), it was not known in the prior art to directly apply the "fill and spill" input circuit to RF signals. Moreover, there was no teaching to such prior art about the desirability of using CCD technology in radio frequency circuit applications.

Summary

Briefly, and in general terms, the invention is concerned with phase or amplitude demodulator circuits, and in particular with broad spectrum demodulators capable of operating in the frequency range from audio frequencies up to the high gigaHertz frequency range, (i.e. 100 GHz or more). The invention is moreover concerned with a semiconductor integrated circuit utilizing charge couple device technology for providing such a demodulator.

The present invention provides for a charge coupled integrated circuit comprising a semiconductor body including a first semi-conductor layer of a first type conductivity, a second semiconductor layer of a second type conductivity at least in part disposed below said first semiconductor layer; first input means for introducing into a first portion of said circuit a predetermined amount of charge; a first region of semiconductor material of said first type conductivity in said first layer and connected to said input means for locally introducing into said first semiconductor layer information in the form of charge consisting of majority charge carriers of said first layer; storage well means functioning to store a predetermined amount of charge in a second portion of said circuit spaced apart from said first portion; second input means disposed between said first region and said storage well means; transfer means connected to said storage well means for transferring said quantity of charge remaining in said storage well means to output means; said output means being disposed adjacent to said transfer means for receiving said quantity of charge remaining in said storage well means; a second region of semiconductor material of said first type conductivity in said first layer and connected to said output means and spaced apart from said first region; an output gate electrically connected to said output means for receiving the charge packets transferred by said transfer means from said storage well means, and reset means for draining said charge from said output gate, said circuit being characterized in that for the purpose of demodulating a time-varying radio-frequency signal containing information in the form of phase or amplitude modulation is fed into said second input means to provide demodulation means functioning to cause charge to be transported during a first time interval from said first portion to said second portion, and during a subsequent second time interval from said second portion in the direction of said first portion, so that at the end of a single first and a predetermined plurality of subsequent successive second time intervals a quantity of charge remains in said storage well means representative of the demodulated amplitude of said time-varying radio-frequency signal.

Preferred modifications of the circuit of the invention are given in the appendant claims.

The novel features which are considered as characteristic for the invention are set forth in particular in the appended claims. The invention itself, however, both as to its construction and its method of operation, together with additional objects and advantages thereof will be best understood from the following description of specifice embodiments when read in connection with the accompanying drawings.

Brief description of the drawings

Fig. 1 is a highly simplified block diagram of the demodulator system according to the present invention;

Fig. 2 is a top plan view of a semiconductor integrated circuit incorporating the present invention;

Fig. 3 is a cross-sectional view of the semiconductor circuit shown in Fig. 2 through the III—III plane, together with a potential diagram of the potential in the semiconductor body under the illustrated electrodes;

Fig. 4 is a timing diagram of the signal waveforms applied to the gates of the semiconductor device according to the present invention; and

Fig. 5 is a timing diagram of the operation of the present invention in demodulating an applied radio frequency signal; and

Fig. 6 is a block diagram of an application of the demodulator system according to the present invention as a phase meter;

Fig. 7 is a chart showing the output of the CCD phase meter and detector according to the present invention depending upon the operation of two diode switches; and

Fig. 8 is a potential diagram of the potential

in the semiconductor body under the active electrodes of the CCD detector shown in Fig. 6.

Description of the preferred embodiment

Turning now to Fig. 1, there is shown a highly simplified block diagram of the demodulator system according to the present invention. A source of a modulated time-varying signal, such as a radio frequency (RF) source is designated by block labeled 10. A clock circuit designated by block labeled 11 provides three non-overlapping clock signals $\phi_1$, $\phi_2$, and $\phi_3$. Such clock signals are applied to the CCD demodulator circuit 12 according to the present invention. The output signal is amplified by an amplifier 13 which provides a demodulated signal of the phase or amplitude modulated time-varying signal according to the present invention.

Turning now to Fig. 2, there is shown a top view of a semiconductor implementation of the CCD demodulator according to the present invention. A monocrystalline silicon semiconductor substrate 40, typically of p-type conductivity, supports the CCD demodulator 12 and the amplifier 13 as shown in Fig. 1.

In the preferred embodiment according to the present invention, a p-type silicon substrate with CCD and MOSFET devices are described, however it must be realized that other semiconductor materials, or other circuits and transistor devices may be used as well.

Fig. 2 in particular shows a first semiconductor region 14 of second conductivity type (e.g. n type) forming a surface region on the semiconductor substrate 40. Formed within the first region 14 are first and second discrete, spaced apart surface subregions 41 and 42 resectively also of n type conductivity but having a dopant concentration higher than that of the region 14. An insulating layer (not shown) lies over the surface regions, except for contact areas which make external electrical connection with active semiconductor regions possible. A contact 17 makes electrical and physical contact with the first semiconductor region 41 for the purpose of supplying an input signal thereto. The contact 17 is connected to an input line 16 which is formed by an aluminum (or polysilicon) layer or strip overlying the insulating layer which is formed on the major surface of the semiconductor substrate 40. The second semiconductor region 42 also includes a contact 45 which makes physical and electrical contact therewith. A corresponding aluminum layer or strip 31 makes electrical connection with the contact 45 and extends over the insulating layer on the surface of the semiconductor substrate 40.

Three gate electrodes 19, 22, and 25 are provided overlying and electrically insulated from the major surface of the semiconductor substrate and disposed between the semiconductor regions 41 and 42. Gate electrodes 19 and 25 are first or lower level polysilicon gates and gate 22 is a second or upper level polysilicon gate which slightly overlies a portion of both gates 19 and 25. These gates are separated from the major surface of the semiconductor wafer and from each other by means of the insulating layer (not shown). Various signal lines are provided which make electrical contact with the gate electrodes. The signal line 18 makes contact with the gate electrode 19 at the contact 20. The gate associated with gate electrode 19 may also be referred to as the "meter gate", or gate $G_1$. The signal line 21 makes contact with the gate electrode 22 by means of the contact 23. The gate associated with gate electrode 22 may be referred to as the "storage gate", or gate $G_2$. The signal line 24 makes contact with the gate electrode 25 at the contact 26. The gate associated with gate electrode 25 may be referred to as the output transfer gate, or gate OTG. The signal lines 18, 21, and 24 are preferably conductive strips composed of aluminum and are disposed on the surface of the insulating layer over the semiconductor substrate.

Fig. 2 also shows the amplifier portion 13 of the circuit according to the present invention including a second semiconductor region 15 of a second conductivity type (i.e. n type) adjacent the major surface and extends from the surface to a predetermined depth into a body. The second semiconductor region 15 is spaced from the first semiconductor region 14 and electrically isolated therefrom by the substrate 40. This second semiconductor region of the second conductivity type further contains first and second spaced-apart semiconductor subregions 43 and 44 respectively of the same second conductivity type adjacent said major surface. The first and second subregions have a second conductivity type forming dopant concentration higher than that of the second semiconductor region itself, such as having n+ type conductivity. Such first and second subregions form the source and drain zones of a field effect transistor which is used as an amplifier for the output signal generated in the present circuit. A first signal line 32 is physically and electrically connected to the first subregion 43 by means of contact 33. A second signal line 34 makes physical and electrical contact with the second subregion 44 by means of the contact 35. The source and drain electrodes may therefore be connected to other elements of the circuit in order to further amplify or utilize the signal, as is known by those skilled in the art.

Fig. 2 also shows the reset means according to the present invention. The reset means is formed by a field effect transistor, including a reset gate electrode 47 and a third semiconductor subregion 46 which is adjacent the major surface of the semiconductor body and lies within the first semiconductor region 14 described above. The third subregion 46 has a second conductivity type forming dopant concentration higher than that of the second semiconductor region itself, such as having n+ type

conductivity, and is spaced apart from the second subregion 42 so that the regions 42 and 46, together with the gate electrode 47 form a field effect transistor. The reset gate electrode 47 is composed preferably of polysilicon and is disposed on the insulating layer (not shown) which lies over the semiconductor structure, and is situated so that its projection normal to the surface of the substrate 40 lies between the second and third subregions 42 and 46 so as to form an insulated gate of a field effect transistor having the source and drain zones constituted by the second and third subregions 42 and 46 respectively. A signal line 48 makes contact with the gate electrode 47 at a contact 49.

A signal known as a reset gate (RG) signal is applied during a third subsequent time interval for the purpose of making the field effect transistor constituted by the subregions 42 and 46 and gate electrode 47 conductive so as to drain the charge located on the output gate 31 at an appropriate time, thereby "resetting" the storage gate to receive further charge from the input. A signal line 50 is further provided which makes contact with the second subregion 46 at the contact 51, which functions to DC bias the amplifier gate during reset.

Fig. 3a is a cross-sectional view of the semiconductor circuit shown in Fig. 2 through the III—III plane. Fig. 3b shows a sequence potential diagram of the electrical potential in the semiconductor body adjacent the major surface in a region corresponding to the region shown in Fig. 3a at successive periods of time. The elements shown in Fig. 3 and labeled by reference numerals have the same meaning as the corresponding elements in Fig. 2, e.g. the input line 17, contact 17, semiconductor body 40, first semiconductor region 14 and second semiconductor region 15, first semiconductor subregion 41 and second semiconductor subregion 42, the third semiconductor subregion 44, gate electrodes 19, 22, and 25, output line 31 and contact 45. Fig. 3a shows the layer of electrically insulating material 52, preferably silicon dioxide, which overlies the major surfaces of the semiconductor body 40 and the semiconductor regions, and electrically insulates the gate electrodes 19, 22, and 25 from the silicon surface, as well as insulates the gate electrode 31 from the surface of the second semiconductor region 15.

The potential diagrams in Fig. 3b in particular indicate the potential level under gate 19 (or $G_1$), under gate 22 (or $G_2$), and under the gate 25 (or the output transfer gate (OTG)). According to the present invention the radio frequency input signal is applied to Gate $G_1$, a fixed bias potential is applied to gate $G_2$, and clock pulse $\phi_2$, as will be described subsequently, is applied to the output transfer gate 25. In the sequence of potential diagrams shown in Fig. 3b, a pulse does not appear on the output transfer gate and thus the potential under the semiconductor region under that gate remains constant during the time period considered.

Fig. 3b shows a sequence of four potential well diagrams taken at successive time intervals $t_0$, $t_1$, $t_2$, and $t_3$, and two further potential well diagrams at a much later time during subsequent time intervals $t_N$ and $t_{N+1}$. During the period of time from $t_0$ to $t_3$ the potential barrier under the gate $G_1$ is seen to decrease from the period $t_0$ to $t_1$ and increase from the period $t_2$ to $t_3$. During this time period the stored charge in the region under the gate $G_2$ slowly begins to diffuse in the left hand direction. At time $t_0$ the potential underneath the gate $G_1$ is at a potential level $V_1$, and at the time $t_1$ the potential under the gate $G_1$ is at a lower level. The level $V_{IN}$ is the initial input voltage applied the charge storage areas by means of the input line 16. The shaded portion represents charge storage in the semiconductor region between the subregions 41 and 42.

The first of the six potential diagrams at $t=t_0$ shows the $G_2$ gate storage charge equilibrated to the DC bias on the $G_1$ gate. Actually, this DC signal equilibration occurs simutaneously with the RF signal, but the superposition principle allows one to treat them separately. At $t=t_1$, the first positive half cycle of the RF signal voltage applied to gate $G_1$ begins exposing the stored charge to a lower potential. This half cycle concludes at $t=t_3$. The third potential diagram represents the situation at $t=t_3$, just before the half cycle conclusion. At this point, a small amount of charge has spilled out of the storage well, but the effective pulse width is so short at millimeter wave frequencies that very little charge transfer has ocurred. Nevertheless, a charge diffusion pattern is emerging that can be divided into three parts denoted by the arrows 1—3. Arrow 1 is a slow diffusion of charge under the $G_1$ gate and $G_2$ has a slow diffusion component labeled by arrow 2. These two diffusion components proceed independent of the sinewave cycle through an application of the superposition principle. A third component labeled by arrow 3 represents a fast charge transfer occurring at the gate boundary. In the fourth diagram at $t=t_3$ the polarity of the RF signal has changed, raising the $G_1$ gate potential. This in turn raises the $G_1$ charge potential so that charge at the $G_1$ boundary flows back to the $G_2$ well. This charge diffusion is denoted by arrow 3'. The net result is the two opposite fast diffusions, 3 and 3', cancel during an RF cycle while the slow diffusions continue without interruption. A cycle that occurs around $t=t_N$ and $t_{N+1}$ ($n>>1$), a much later time, is illustrated in the final two diagrams. Here it is seen that the slow diffusion has resulted in a cosine profile for the exposed excess charge originally in the $G_2$ well.

Since the fast diffusion alternates direction giving no net transfer, and the superposition principle holds in this linear system, it is justified to neglect the fast diffusion and treat just

the slow diffusion. The time allowed for the slow diffusion is the total time between the $\phi_1$ input diffusion pulse and the $\phi_2$ output transfer gate pulse which can be 1 us or longer. This is plenty of time to spill the excess charge and equilibrate the charge stored in $G_2$ to the $G_1$ potential minimum determined by the RF signal amplitude.

Fig. 4 is a timing diagram of the signal waveforms applied to the gates of the semiconductor device according to the present invention. The first timing signal is the timing signal applied to the input diffusion line 16 and is labeled $\phi_1$ in Fig. 4 as well as in Fig. 1. The signal $\phi_1$ remains essentially high (or at ground potential) until a time $t_a$ at which point it drops to a relatively negative potential where it remains for a predetermined time as short as a few nanoseconds. After such period has elapsed, at $t_b$, the signal returns to ground potential where it remains until the cycle is continued. Such a signal occurs during a first time interval and functions to inject charge into the charge storage region thereby filling the storage well under the gate $G_2$ to a level determined purely by the height of the potential well under the level $G_1$. This is represented on the Fig. 3 by time $t_0$ in which the storage well under the gate $G_2$ has been filled exactly to the height of the signal applied to the gate $G_1$. This initiates the sample aperture which ends when the output transfer gate is pulsed.

The $\phi_2$ signal shown in Fig. 4 applied to the output transfer gate is defined by a waveform going from a relatively negative voltage level to a relatively positive level for a time interval of at least 100 ns. for a typical 6 $\mu$m gate dimension. The function of the outout transfer gate signal is to transfer the charge stored in the region underneath $G_2$ into the semiconductor region 42 and thence onto the gate 31.

The final third timing diagram shown in Fig. 4 is the $\phi_3$ signal applied to the reset gate (RG) which in Fig. 2 is the gate 47. The $\phi_3$ waveform changes from a relatively low voltage to a relatively high voltage, and remains at the relatively high voltage for a period of at least 100 ns. which occurs during a third time interval subsequent to the second and the first time interval.

Following the sequence of consecutive pulses associated with waveforms $\phi_1$, $\phi_2$, and $\phi_3$ respectively, the cycle repeats itself with a $\phi_1$ pulse as is shown in the diagram in Fig. 4. The output proportional to the RF signal amplitude appears as a pulse at the output FET source line 32 in the time between the $\phi_2$ and $\phi_3$ pulses.

Fig. 5 is a timing diagram of the operation of the present invention in demodulating the applied radio frequency signal. The Figure's first waveform shows the typical amplitude modulated radio frequency signal that might be applied to the $G_1$ gate. The second waveform shown is the sample pulse or the $\phi_1$ waveform. The third shows the output waveform produced by the present invention having as an input the radio frequency input signal shown in Fig. 4. The output signal represents the demodulation of the radio frequency signal shown above in Fig. 5. The output signal shown in Fig. 5 is produced by a voltage or current variation of a signal in the conduction path of the field effect transistor defined by 43, 31, and 44 in Fig. 2.

Fig. 6 is a highly simplified block diagram of an application of a CCD demodulator according to the present invention as a phase meter, which functions to distinguish the phase of two applied signals. Alternatively, the present invention may be used in performing detection of a phase modulated signal, in which case one of the signals applied to the demodulator is a reference signal having a known phase.

The signals $S_1$ and $S_2$ are applied to two diode switches 60 and 61 respectively. As an example of two different signals of different amplitude and phase, signal $S_1$ is represented as being of the form A sin $\omega$t and signal $S_2$ is represented as being of the form B sin $(\omega t+\phi)$, where A and B are constants, $\omega$ is frequency and t is time. Each of the diode switches has two possible positions, either an "on" state or an "off" state. Control of the diode switches is performed by the timing and bias circuit 63. In one modulation period, the diode switches go through each of the four possible combination of positions:

diode switch 60 on, diode switch 61 on
diode switch 60 on, diode switch 61 off
diode switch 60 off, diode switch 61 on
diode switch 60 off, diode switch 61 off

The selection of the positions of the diode switches is performed by the timing and bias circuit 63 in a predetermined order so that in four equal and successive time intervals, each position is selected. The output of the two diode switches are applied to the gates $G_1$ and $G_2$ of the CCD demodulator as shown in Fig. 3a.

The output of the CCD demodulator (which is now labeled as a "CCD phase meter and detector") in block 62, takes one of four possible values depending upon the settings of the diode switches 61 and 62. The four possible output values Q are shown above the output line by $Q=Q_C-Q_A+Q_B \cos \phi$, $Q_C$, $Q_C-Q_A$, and $Q_C-Q_B$. The value $Q_C$ is defined as the voltage output of the demodulator 62 when no time-varying signal is applied to the input gates (i.e. a DC bias signal is alone applied to the gates). $Q_A$ is a voltage proportional to the input amplitude A, and $Q_B$ a voltage proportional to the input amplitude B. Which of these Q values are output by the demodulator 62 is determined according to the settings of the diode switches 61 and 62 at a specific time as is shown in Fig. 7. Note that when both AC signals are applied to demodulator 62 (i.e. A sin $\omega$t and B sin $(\omega t+\phi)$ the output has a term proportional to cos $\phi$, where $\phi$ is the phase difference.

The output of the CCD phase meter 62 is an analog signal which may preferably be converted to a digital signal for further processing. The analog output signal is therefore applied to a conventional A/D converter 64 which converts the analog output from the CCD output gate to a digital signal for such further processing. The output of the A/D converter 64 is shown as an 8-bit data output line applied to a microprocessor 65. The timing and bias circuit 63 provides timing and bias signals to the A/D converter 64 as well as the microprocessor 65. The four output values for Q for one modulation period are used in the microprocessor 65 to calculate in real time the amplitudes of the two applied signals and their phase difference. The phase difference $\phi$ may be calculated for each modulation period by use of the formula

$$\phi=\cos^{-1}[(Q-Q_C+Q_A)/Q_B].$$

The specific choice of microprocessor and the programming thereof for use in the described application would be within the skill of a person familiar with the programming art. Temperature and bias drift are accounted for by the $Q_C$ output. Signal amplitude variations are accounted for by the $Q_C-Q_A$ and $Q_C-Q_B$ outputs.

One important application for the present invention as a phase meter is in a data transmission system for sending digital data between a transmitter and a receiver over a transmission line, in which predetermined phase differences and predetermined amplitude levels are established in a carrier signal during successive modulation periods representative of preselected data combinations. The demodulator at the receiver according to the present invention functions to detect the phase differences and the amplitude levels and restore the digital data to its original format.

In such an application the phase and amplitude modulated carrier signal is applied to the input of one of the diode switches, e.g. diode switch 60, and a reference signal applied to the other diode switch, e.g. diode switch 61. The diode switches 60 and 61 are then sequentially switched on and off by the timing and bias circuit 63 so that the four possible output signals are generated. As explained above, the output signals are applied to the A/D converter 64 to produce digital signals which are applied to the microprocessor 65. The microprocessor produces a multibit digital output representing the phase difference between the input signal and the reference signal.

Fig. 8 is a potential diagram of the potential in the semiconductor body under the gates $G_1$, $G_2$, and the output transfer gate under various conditions. Each of the levels of potential shown in the diagram of Fig. 8 are labeled according to the potential which has been applied to the gate and therefore which is reflected in the potential level in the semiconductor body under the respective gate. The minimum difference in levels between gates $G_1$ to $G_2$ is represented by the arrows shown in the right hand portion of the figure and is proportional to the device output. These different signals are as follows:

$Q_C$ is the difference between the DC meter gate and storage gate potentials and is proportional to the DC output.

$Q_C-Q_A$ is the difference between the DC storage gate potential and the minimum AC modulated meter gate potential and is proportional to the AC signal amplitude, A, and the DC+AC amplitude output.

$Q_C-Q_B$ is the difference between the DC meter gate potential and the maximum AC modulated storage gate potential and is proportional to the AC signal amplitude, B, and the DC+AC amplitude output.

$Q_C-Q_A+Q_B\cos\phi$ at an angle $\phi=180°$ is the difference between the minimum AC modulated meter gate potential and the maximum AC storage gate potential or $Q_C-Q_A-Q_B$ and is proportional to the device output.

$Q_C-Q_A+Q_B\cos\phi$ at an angle $\phi=0°$ is the difference between the minimum AC modulated meter gate potential and the minimum AC storage gate potential or $Q_C-Q_A+Q_B$ and is proportional to the device output.

It will be obvious to those skilled in the art that the semiconductor device according to the present invention can be manufactured with various semiconductor technologies and different combinations of known process steps, and that the preferred embodiments illustrated here are merely exemplary. The depth of penetration of the various zones and regions and in particular the configuration and distance between the active zones of the transistor devices, as well as the concentrations of dopant species, and/or their concentration profiles, can be chosen depending upon the desired properties.

The present invention is also not restricted to the specific semiconductor materials and circuits described. For example, it may be pointed out that semiconductor materials other than silicon, for example $A_{III}$—$B_V$ compounds, may be used, Furthermore, the conductivity types in the embodiment may be interchanged and corresponding to such change, the polarity of the respective operating voltages adapted. Moreover, the voltage level and the static or dynamic nature of the signals applied to the various terminals and gates of the device, as well as the voltage sources, may be suitably selected as desired for a particular application.

**Claims**

1. A charge coupled integrated circuit comprising a semiconductor body including a first

semiconductor layer (14) of a first type conductivity, a second semiconductor layer (40) of a second type conductivity at least in part disposed below said first semiconductor layer (14);

first input means (IN;16) for introducing into a first portion of said circuit a predetermined amount of charge;
a first region (41) of semiconductor material of said first type conductivity in said first layer (14) and connected to said input means (IN;16) for locally introducing into said first semiconductor layer (14) information in the form of charge consisting of majority charge carrier of said first layer;
storage well means (under G2, Fig. 3a, 3b) functioning to store a predetermined amount of charge in a second portion of said circuit spaced apart from said first portion;
second input means (G1, 19) disposed between said first region and said storage well means;
transfer means (OTG) connected to said storage well means for transferring said quantity of charge remaining in said storage well means to output means (31);
said output means (31) being disposed adjacent to said transfer means (OTG) for receiving said quantity of charge remaining in said storage well means;
a second region (42) of semiconductor material of said first type conductivity in said first layer (14) and connected to said output means (31) and spaced apart from said first region (41);
an output gate (45) electrically connected to said output means (31) for receiving the charge packets transferred by said transfer means (OTG) from said storage well means, and reset means for draining said charge from said output gate;

characterized in that for the purpose of demodulating a time-varying radio-frequency signal containing information in the form of phase or amplitude modulation is fed into said second input means (G1, 19) to provide demodulation means functioning to cause charge to be transported during a first time interval from said first portion to said second portion, and during a subsequent second time interval from said second portion in the direction of said first portion, so that at the end of a single first and a predetermined plurality of subsequent sucessive second time intervals a quantity of charge remains in said storage well means representative of the demodulated amplitude of said time-varying radio-frequency signal.

2. A circuit as claimed in Claim 1 wherein a signal amplifier is connected to said output means and comprises a field effect transistor having first (source) and second (drain) output electrodes (43, 44), and wherein a control electrode is connected to said output gate.

3. A circuit as defined in Claim 1 or 2, wherein said reset means comprises a field effect transistor (42, 46, 47) disposed in said semiconductor body.

4. A data transmission system for sending digital data between a transmitter and a receiver over a transmission link by establishing predetermined phase differences and predetermined amplitude levels in a carrier signal during successive modulation periods representative of preselected data combinations comprising a demodulator (62) at the receiver for detecting said phase differences and said amplitude levels to restore the digital data to its original format which comprises:

a carrier signal input for supplying a carrier signal;
a reference signal input for supplying a reference signal;
a first switch means (60) connected to said carrier signal input;
second switch means (61) connected to said reference signal input;
a charge coupled demodulator circuit as defined in any of claims 1—3 and having an input connected to said first and second switch means, and an output; said demodulator functioning to demodulate the signal applied to its input;
timing means (63) connected to and controlling said first and second switch means for providing a predetermined signal input to said demodulator; and
processing means connected to the output of said demodulator for calculating the phase difference between said carrier signal and said reference signal.

5. A system as defined in Claim 4, wherein said first and second switch means comprises diode switches (60, 61).

6. A system as defined in Claim 4 or 5, wherein said processing means comprises:

an analog-to-digital converter having an input connected to said output of said demodulator circuit, and an output; and
a microprocessor (65) having an input connected to said output of said analog-to-digital converter for digitally calculating the phase difference between said carrier signal and said reference signal.

**Patentansprüche**

1. Ladungsgekoppelte integreirte Schaltung, welche folgendes aufweist: einen Halbleiterkorper mit einer ersten halbleiterschicht (14) einer ersten Leitfähigkeitstype, einer sweiten Halbleiterschicht (40) einer zweiten Leitfähigkeitstype, die mindestens teilweise unterhalb der ersten Halbleiterschicht (14) angeordnet ist,

erste Eingangsmittel (IN; 16) zur Einführung einer vorbestimmten Ladungsmenge in einer ersten Teil der Schaltung,

eine erste Zone (41) aus Halbleitermaterial der ersten Leitfähigkeitstype in der ersten Schicht (14), und zwar verbunden mit den Eingangsmitteln (IN; 16) zur örtlichen Einführung von Information in die erste Halbleiterschicht (14) in der Form einer Ladung bestehend aus Majoritätsladungsträgern der ersten Schicht, Speicherquellen oder well-Mitteln (unter G2, Fig. 3a, 3b), die eine vorbestimmte Ladungsmenge in einem zweiten Teil der Schaltung mit Abstand angeordnet gegenüber dem ersten Teil speichern, sweite Eingangsmitteln (G1, 19) angeordnet zwischen der ersten Zone und den Speicherquellenmitteln,

Transfermitteln (OTG) verbunden mit den Speicherquellenmitteln zum Transfer der in den Speicherquellenmitteln verbleibenden Ladungsmenge zü den Ausgangsmitteln (31),

wobei die Ausgangsmittel (31) benachbart zu den Transfermitteln (OTG) angeordnet sind zum Empfang der in den Speicherquellenmitteln verbleibenden Ladungsmenge,

eine zweite Zone (42) aus Halbleitermaterial der ersten Leitfähigkeitstype in der ersten Schicht (14) und verbunden mit den Ausgangsmitteln (31) und mit Abstand angeordnet gegenüber de ersten Zone (41),

ein Ausgangsgate (45) elektrisch verbunden mit den Ausgangsmitteln (31) zum Empfang der Ladungspakete tranferiert durch die Transfermittel (OTG) von den Speicherquellenmitteln, und Rückstellmittel zum Ablassen der Ladung von dem Ausgangsgate,

dadurch gekennzeichnet, daß zum Zwecke der Demodulation ein zeitlich variierendes Hochfrequenzsignal, welches Information in der Form von Phasen-oder Amplitudenmodulation enthält, in die zweiten Eingangsmittel (G1, 19) eingespeist wird, un Demodultionsmittel vorzusehen, die bewirken, daß Ladung während des ersten Zeitintervalls von dem ersten Teil zu dem zweiten Teil transportiert wird, und während eines darauffolgenden zweiten Zeitintervalls von dem zweiten Teil in der Richtung des ersten Teils derart, daß am Ende eines einzigen ersten und einer vorbestimmten Vielzahl von darauffolgenden aufeinanderfolgenden zweiten Zeitintervallen eine Laungsmenge in den Speicherquellenmitteln verbleibt, welche für die demodulierte Amplitude des sich zeitlich variierenden Hockfrequenzsignals repräsentativ ist.

2. Schaltung nach Anspruch 1, wobei ein Signalverstärker mit den Ausgangsmitteln verbunden ist und einen Feldeffekttransistor aufweist, und zwar mit ersten (Quelle) und zweiten (Drain) Ausgangselektroden (43, 44), und wobei eine Steurelektrode mit dem Ausgangsgate in Verbindung steht.

3. Schaltung nach Anspruch 1 oder 2, wobei die Rückstellmittel einen Feldeffekttransistor (42, 46, 47) angeordnet in dem Halbleiterkörper aufweisen.

4. Ein Datenübertragungssystem zum Senden von Digitaldaten zwischen einem Sender und einem Empfähger über ein Sende glied durch Vorsehen vorbestimmter Phasendifferenzen und vorbestimmter Amplitudenpegel in einem Trägersignal während aufeinanderfolgender Modulationsperioden repräsentativ für vorgewählte Datenkombinationen, wobei ein Demodulator (62) beim Empfänger vorgesehen ist, um die Phasendifferenzen und die Amplitudenpegel zu detekteren, um die Digitaldaten in ihr ursprungliches Format zurückzubringen wobei folgendes vorgesehen ist:

ein Trägersignaleingang zur Lieferung eines Trägersignals,

ein Bezugssignaleingang zur Lieferung eines Bezugssignals,

erste Schaltmittel (60) verbunden mit dem Trägersignaleingang,

zweite Schaltmittel (61) verbunden mit dem Bezugssignaleingang,

eine ladungsgekoppelte Demodulatorschaltung nach einem der Ansprüche 1 bis 3, und mit einem Eingang verbunden mit den ersten und zweiten Schaltmitteln und mit einem Ausgang, wobei der Demodulator die Demodulation des an seinen Eingang angegelegten Signals bewirkt, und wobei ferner Zeitsteuermittel (63) vorgesehen sind und mit den ersten und zweiten Schaltmitteln verbunden sind und diese steuern, um eine vorbestimmte Signaleingangsgröße für den Demodulator vorzusehen, und mit Verarbeitungsmitteln verbunden mit dem Ausgang des Demodulators zur Berechnung der Phasendifferenz zwischen dem Trägersignal und de Bezugssignal.

5. System nach Anspruch 4, wobei die ersten und zweiten Schaltmittel Diodenschalter (60, 61) aufweisen.

6. System nach Anspruch 4 oder 5, wobei die Verarbeitungsmittel folgendes aufweisen: einer Analog/Digital-Umwandler mit einem Eingang verbunden mit dem Ausgang der Demodulatorschaltung und mit einem Ausgang, und ferner mit einem Mikroprozessor (65), der einen Eingang verbunden mit dem Ausgang des Analog/Digital-Umwandlers aufweist, um digital die Phasendifferenz zwischen dem Trägersignal und dem Bezugssignal zu berechnen.

**Revendications**

1. Circuit intégré à transfert de charges comprenant un corps semi-conductor comportant une première couche semi-conductrice (14) d'un premier type de conductivité, une seconde couche semi-conductrice (40) d'un second type de conductivité au moins en partie placée sous la première couche semi-conductrice (14),

un premier dispositif d'entrée (IN; 16) destiné à introduire dans une première partie du circuit, une quantité prédéterminée de charge,

une première région (41) de matière semiconductrice du premier type de conductivité, dans la première couche (14) et reliée au dispositif d'entrée (IN; 16) afin qu'une information sous forme d'une charge consistant en porteurs majoritaires de charge de la première couche soit introduite localement dans la première couche semi-conductrice (14),

un dispositif à puits de mémorisation (sous $G_2$ figures 3a, 3b) destiné à mémoriser une quantité prédéterminée de charge dans une seconde partie du circuit à distance de la première partie,

un second dispositif d'entrée ($G_1$, 19) disposé entre la première région et le dispositif à puits de mémorisation,

un dispositif de transfert (OTG) relié au dispositif à puits de mémorisation et destiné à transférer ladite quantité de charge restant dans le dispositif à puits de mémorisation vers un dispositif de sortie (31),

le dispositif de sortie (31) étant adjacent au dispositif de transfert (OTG) afin qu'il reçoive ladite quantité de charge restant dans le dispositif à puits de mémorisation,

une seconde région (42) de matière semiconductrice du premier type de conductivité dans la première couche (14) et reliée au dispositif de sortie (31) et à distance de la première région (41),

une grille de sortie (45) reliée électriquement au dispositif de sortie (31) et destinée à recevoir les paquets de charges transférés par le dispositif de transfert (OTG) à partir du dispositif à puits de mémorisation, et un dispositif de remise à zéro destiné à évacuer la charge provenant de la grille de sortie,

caractérisé en ce qu'un signal à haute fréquence variant au cours du temps, contenant une information sous forme d'une modulation de phase ou d'amplitude, est transmis, pour être démodulé, au second dispositif d'entrée (G1, 19) afin qu'il constitue un dispositif de démodulation destiné à provoquer le transport d'une charge pendant un premier intervalle de temps de la première partie à la seconde partie, et pendant un second intervalle de temps suivant de la seconde partie vers la première partie, si bien que, à la fin d'un seul premier intervalle de temps et d'un nombre prédéterminé de seconds intervalles de temps sucessifs, une quantité de charge reste dans le dispositif à puits de memorisation en étant représentative de l'amplitude démodulée du signal à haute fréquence variant au cours du temps.

2. Circuit selon la revendication 1, dans lequel un amplicateur de signaux est relié au dispositif de sortie et comporte un transistor à effet de champ ayant une première (source) et une seconde (drain) électrode de sortie (43, 44), et dans lequel une électrode de commande est reliée à la grille de sortie.

3. Circuit selon l'une des revendications 1 et 2, dans lequel le dispositif de remise à zéro comporte un transistor à effet de champ (42, 46, 47) disposé dans le corps semi-conducteur.

4. Système de transmission de données destiné à transmettre des données numériques entre un émetteur et un récepteur par une liaison de transmission, par établissement de différences prédéterminées de phase et de niveaux prédétérminés d'amplitude dans un signal de porteuse au cours de périodes successives de modulation représentatives de combinasions prédeterminées de données, comprenant un démodulateur (62) placé au niveau du récepteur et destiné à détecter les différences de phase et les niveaux d'amplitude afin qu'il rétablisse les données numériques à leur format d'origine, comprenant:

une entrée de signal de porteuse destinée à transmettre un signal de porteuse,

une entrée de signal de référence destinée à transmettre un signal de référence,

un premier dispositif de commutation (60) relié à l'entrée de signaux de porteuse,

un second dispositif de commutation (61) relié à l'entrée de signaux de référence,

un circuit démodulateur à transfert de charges tel que défini dans l'une quelconque des revendications 1 à 3 et ayant une entrée reliée au premier et au second dispositif de commutation, et une sortie, le démodulateur assurant la démodulation du signal appliqué à son entrée,

un dispositif de synchronisation (63) relié au premier et au second dispositif de commutation et commandant ceux-ci afin qu'ils forment un signal prédéterminé d'entrée destiné au démodulateur, et

un dispositif de traitement relié à la sortie du démodulateur et destiné à calculer le déphasage entre le signal de porteuse et le signal de référence.

5. Système selon la revendication 4, dans lequel le premier et le second dispositif de commutation sont des commutateurs à diodes (60, 61).

6. Système selon les revendication 4 et 5, dan lequel le dispositif de traitement comporte:

un convertisseur analogique-numérique ayant une entrée à la sortie du circuit démodulateur, et une sortie, et

un microprocesseur (65) ayant une entrée reliée à la sortie du convertisseur analogique-analogique afin qu'il calcule numériquement le déphasage entre le signal de porteuse et le signal de référence.

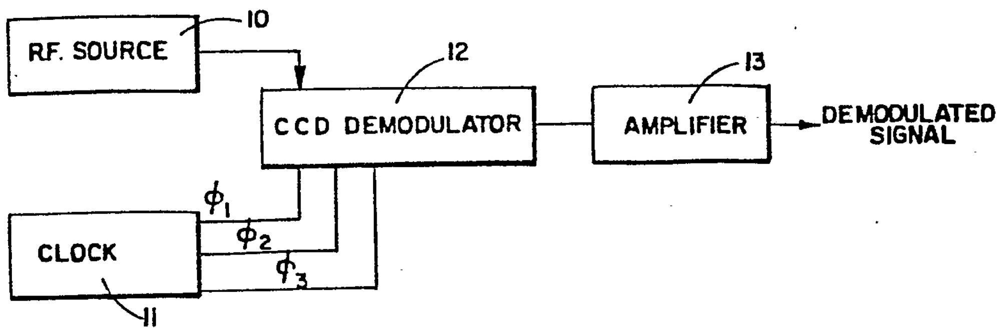


FIG. 1

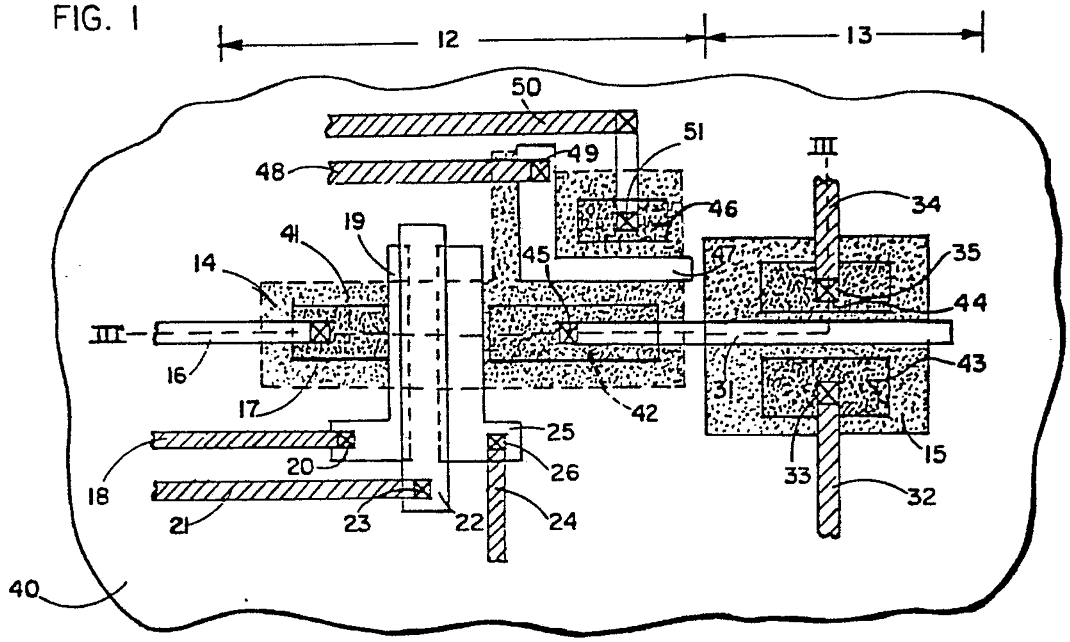


FIG. 2

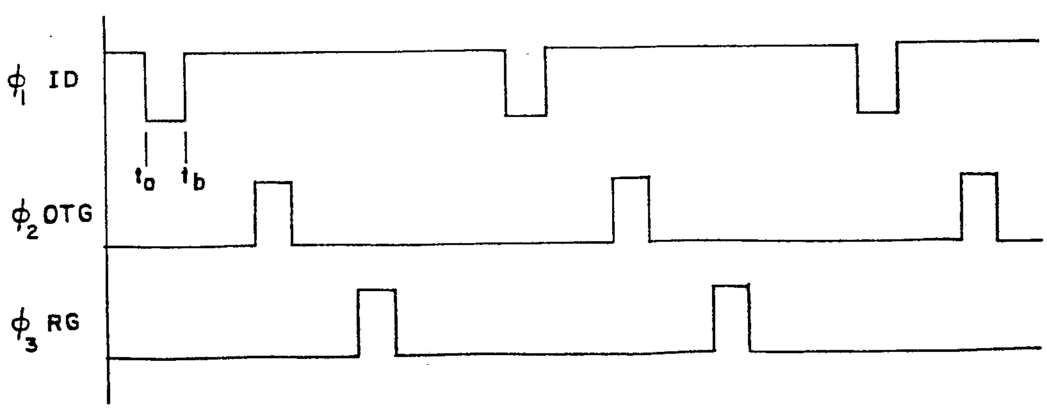


FIG. 4

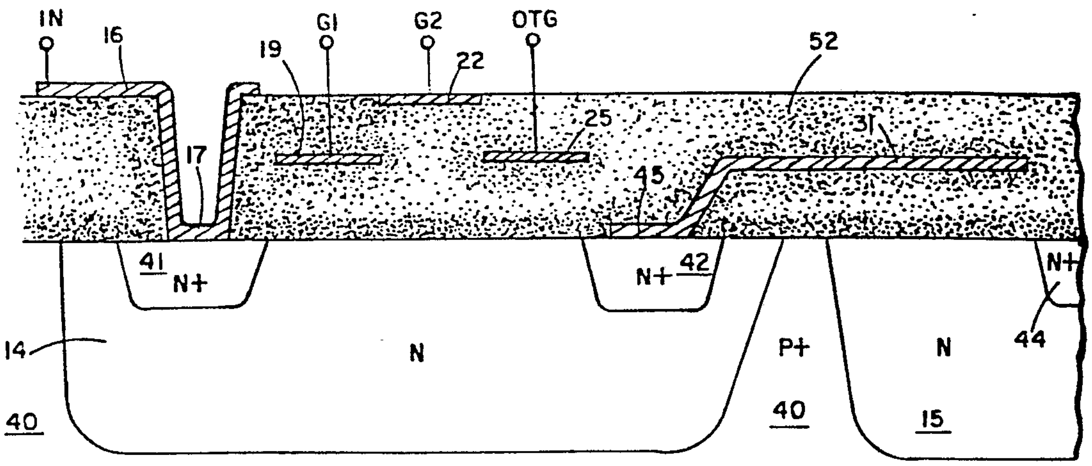
IN
16
19
G1
G2
22
OTG
52
25
31
17
45
41
N+
N+
42
N+
14
N
P+
N
44
40
40
15

FIG. 3a

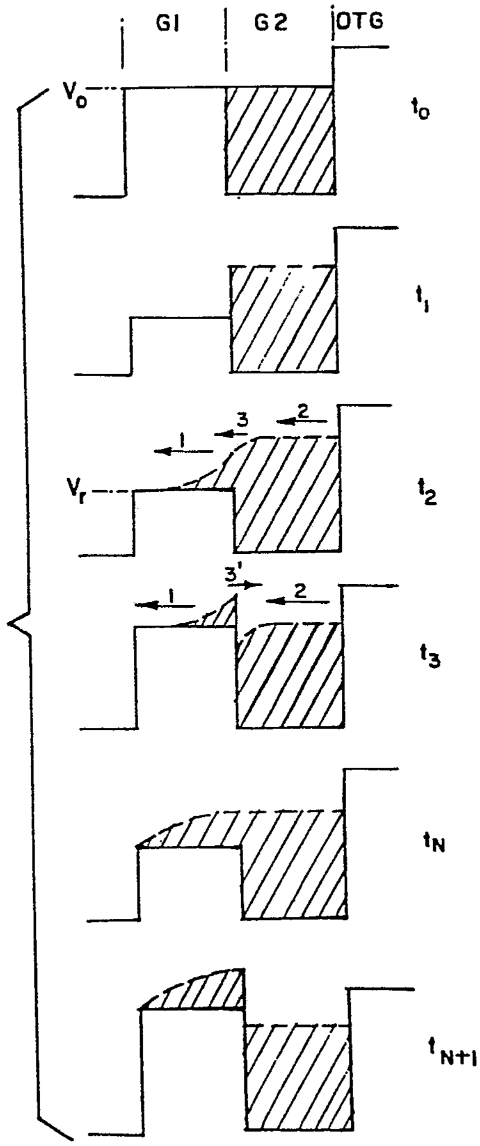
G1
G2
OTG
V0
t0
t1
1
3
2
Vr
t2
1
3'
2
t3
tN
tN+1

FIG. 3b

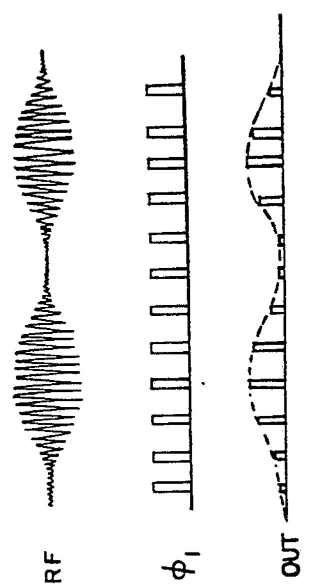
RF
$\phi_1$
OUT

FIG. 5

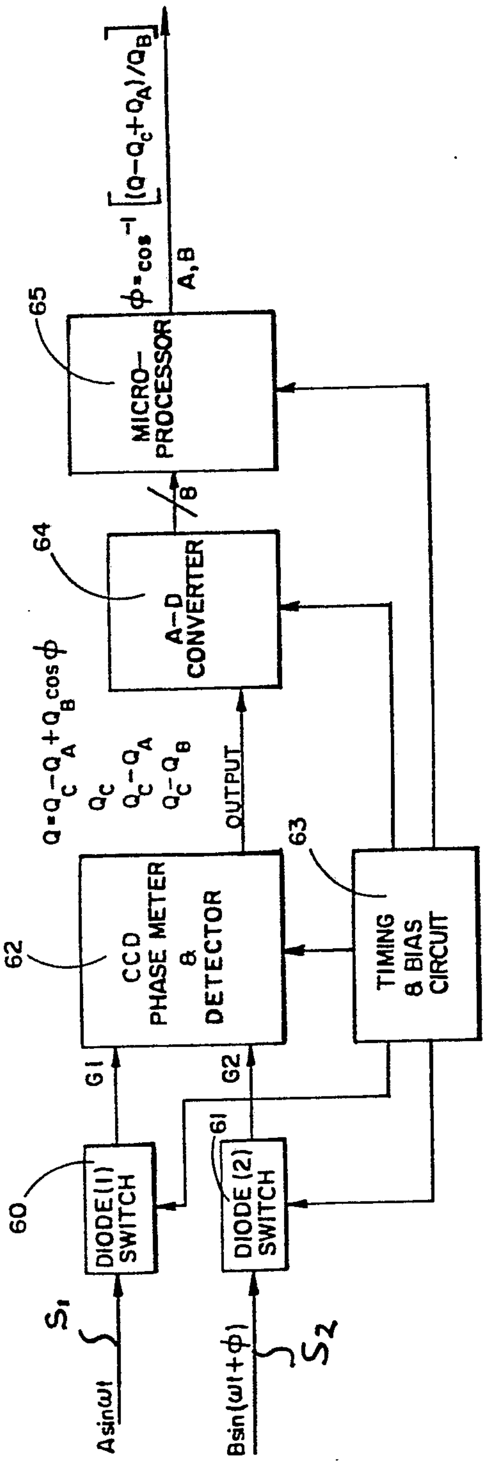
$A\sin\omega t$
$S_1$
$B\sin(\omega t+\phi)$
$S_2$
60
DIODE (1) SWITCH
61
DIODE (2) SWITCH
G1
G2
62
CCD PHASE METER & DETECTOR
63
TIMING & BIAS CIRCUIT
OUTPUT
$Q=Q_C-Q_A+Q_B\cos\phi$
$Q_C$
$Q_C-Q_A$
$Q_C-Q_B$
64
A–D CONVERTER
8
65
MICRO-PROCESSOR
A, B
$\phi=\cos^{-1}\left[(Q-Q_C+Q_A)/Q_B\right]$

FIG. 6

| DIODE (1) SWITCH / DIODE (2) SWITCH | ON | OFF |
|---|---|---|
| ON | $Q = Q_C - Q_A + Q_B \cos\phi$ | $Q_C - Q_B$ |
| OFF | $Q_C - Q_A$ | $Q_C$ |

FIG. 7

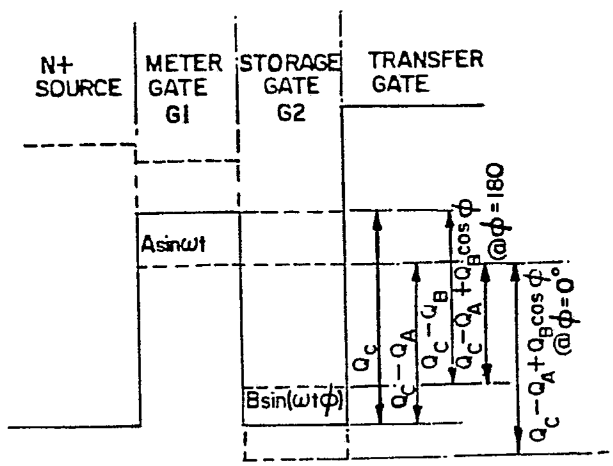


FIG. 8